Europäisches Patentamt

European Patent Office

Office européen des brevets

(11) Publication number: 0 370 830
A2

# EUROPEAN PATENT APPLICATION

(21) Application number: 89312236.6

(22) Date of filing: 24.11.89

(51) Int. Cl.⁵: H01S 3/25

(30) Priority: 25.11.88 JP 299357/88

(43) Date of publication of application:
30.05.90 Bulletin 90/22

(84) Designated Contracting States:
DE FR GB NL

(71) Applicant: **Director-General of the Agency of Industrial Science and Technology**
**Ministry of International Trade & Industry 3-1**
**Kasumigaseki 1-chome**
**Chiyoda-ku Tokyo 100(JP)**

Applicant: **MITSUBISHI KASEI CORPORATION**
**5-2, Marunouchi 2-chome Chiyoda-ku**
**Tokyo 100(JP)**

(72) Inventor: **Suzuki, Yoshihiro Agency of Ind.**
**Science and Tech.**
**Electro Technical Laboratory 1-1-4 Umezono**
**Tsukuba-shi Ibaraki 305(JP)**
Inventor: **Yajima, Hiroyoshi Agency of Ind.**
**Science and Tech.**
**Electro Technical Laboratory 1-1-4 Umezono**
**Tsukuba-shi Ibaraki 305(JP)**
Inventor: **Shimada, Junichi Agency of Ind.**
**Science and Tech.**
**Electro Technical Laboratory 1-1-4 Umezono**
**Tsukuba-shi Ibaraki 305(JP)**
Inventor: **Shimoyama, Kenji Mitsubishi Kasei**
**Corporation**
**Sogo Kenkyujo 1000 Higashi Mamiana-cho**
**Ushiku-shi Ibaraki 300-12(JP)**
Inventor: **Gotoh, Hideki Mitsubishi Kasei**
**Corporation**
**Sogo Kenkyujo 1000 Higashi Mamiani-cho**
**Ushiku-shi Ibaraki 300-12(JP)**

(74) Representative: **Bubb, Antony John Allen et al**
**GEE & CO. Chancery House Chancery Lane**
**London WC2A 1QU(GB)**

(54) Semiconductor laser device having a plurality of active layers.

(57) A semiconductor laser device of a lateral junction type has a plurality of active layers (119,121) laminated by being interposed between clad layers (111,113,115, 117) so that carriers can be injected into the active layers in the vertical and/or lateral directions, thereby enabling carrier injection over a large area and, hence, emission over a large area.

# FIG. 1

# SEMICONDUCTOR LASER DEVICE HAVING A PLURALITY OF ACTIVE LAYERS

This invention relates generally to semiconductor laser devices for producing laser light and, more particularly, to a semiconductor laser device having a plurality of active layers for laser oscillation of a large area.

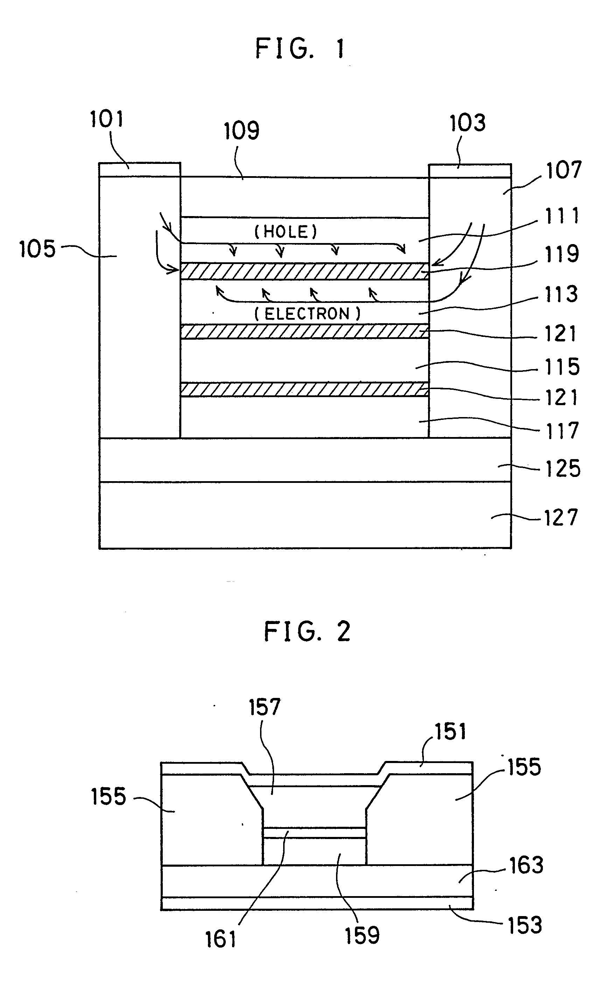

Fig. 2 shows the basic structure of a conventional semiconductor laser device.

The laser device shown in Fig. 2 includes a double-hetero-structure which is formed on a GaAs substrate 163 and in which a GaAs active layer 161 grown to have a thickness of, ordinarily, about 0.2 μm is interposed between an n-AlGaAs clad layers 159 and a p-AlGaAs clad layer 157. Semi-insulating AlGaAs clad layers are formed on the left-hand and right-hand sides of the GaAs active layer 161, and an (+) electrode 151 and an (-) electrode 153 are formed over and under these layers.

In the thus-constructed laser device, a current is made to flow from the electrode 151 to the electrode 153 vertically as viewed in Fig. 2. Carriers and electrons are thereby injected into the GaAs active layer 161 having a band gap smaller than those of the p-AlGaAs clad layer 157 and the n-AlGaAs clad layer 159, so that light is generated by recombination of electrons and holes. The generated light is confined between and guided by the upper and lower, left and right clad layers, thereby emitting laser light in the direction perpendicular to the plane of projection of Fig. 2.

To increase the amount of laser light emission, it is necessary to increase the sectional emission area. To increase the sectional emission area in the conventional laser device shown in Fig. 2, however, it is necessary to increase the thickness of the active layer as well as the width of the same.

If the sectional area of the active layer is thereby increased, the densities of injected electrons and holes are reduced, resulting in an increase in the threshold current required for laser oscillation. Also, the emission becomes non-uniform if the thickness of the active layer is large, and it is therefore difficult to effect emission of a large area.

In view of these problems, an object of the present invention is to provide a semiconductor laser device designed to effect large-area emission without reducing the emission efficiency, to set the emission intensity distribution as desired and to thereby effect large-area emission with a reduced astigmatism.

To achieve this object, according to the present invention, there is provided a lateral junction type semiconductor laser device in which a plurality of active layers are laminated by being interposed between clad layers. The clad layers sandwiching the active layers are p-type and n-type clad layers, p-type or n-type clad layers, or undoped layers.

An embodiment of the present invention will be described below with reference to the accompanying drawings, in which:

Fig.1 is a diagram of a semiconductor laser device which represents an embodiment of the present invention; and

Fig 2 is a diagram of the basic structure of a conventional semiconductor laser device.

Fig.1 shows a semiconductor laser device which represents an embodiment of the present invention. The semiconductor laser device in Fig.1 has an (+) electrode 101, an (-) electrode 103, a p-AlGaAs clad layer 105, an n-AlGaAs clad layer 107, a semi-insulating AlGaAs clad layer 109, a p-AlGaAs clad layer 111, an n-AlGaAs clad layer 113, a p-AlGaAs clad layer 115, an n-AlGaAs clad layer 117, GaAs active layers 119, 121 and 123, a semi-insulating AlGaAs clad layer 125, and a substrate 127.

As shown in Fig. 1, the semi-insulating AlGaAs clad layer 125 is formed on the substrate, the active layers 119, 121, and 123 are laminated thereon with the p-type clad layers 111 and 115 and the n-type clad layers 113 and 117 sandwiching the active layers, and the semi-insulating AlGaAs clad layer 109 is formed on this lamination. The p-type clad layer 105 and the n-type clad layer 107 are buried on left-hand and right-hand sides of the layers formed on the AlGaAs clad layer 125. The electrodes 101 and 103 are formed on the p-type clad layer 105 and the n-type clad layer 106. The thickness of each active layer ranges from about 3 to 300 nm. The thickness of the p-type and n-type clad layers sandwiching the active layers in the vertical direction as viewed in Fig. 1 may be selected as desired but it is, preferably, within a range of about 0.1 to 1 μm. The proportion of Al in the active layers may be 0.4 or less or preferably 0.3 or less or, more preferably, 0.15 or less. The proportion of Al in the clad layers is at least larger than that in the active layer and is ordinarily 0.2 to 0.8.

In the thus-constructed semiconductor laser device, a current is made to flow between the (+) electrode 101 and the (-) electrode 103, and holes and electrons are thereby injected from the upper and lower, and left and right clad layers into the active layers having a smaller energy gap. Injection of electrons and holes into each active layer can therefore be effected over a large area. Even though the number of active layers is increased in order to increase the total area of the active layers in this manner, a high carrier density can be maintained for one active layer, thereby achieving a large-area emission without reducing the emission efficiency.

It is also possible to change the distribution of the emission intensity in the vertical direction as desired by selecting the thicknesses of the clad layers between the active layers. Large-area laser emission can therefore be realized while limiting the astigmatism.

In the above-described embodiment, the active layers are interposed between the p-type and n-type clad layers. However, if the width of the active layers is so small (10 $\mu$m or less or, preferably, 5 $\mu$m or less) that the amount of carriers injected from the left and right clad layers alone is sufficient, the active layers may be interposed between layers of one type, e.g., p-type clad layers, n-type clad layers, or undoped layers.

In accordance with the present invention, as described above, a plurality of thin active layers each of which has the same area as the conventional arrangement are provided so that the overall thickness of the active layers is increased, thereby enabling the carrier density in each active layer to be maintained at a high level and achieving large-area emission without reducing the emission efficiency. The distribution of the emission intensity in the vertical direction can be changed as desired by selecting the thicknesses of the clad layers between the active layers, thereby realizing large-area laser emission with a reduced astigmatism.

## Claims

1. A multi-active-layer semiconductor laser device having a lateral junction type buried semiconductor laser structure formed on a semi-insulating substrate (127,125), said laser device comprising a plurality of active layers (119,121) and a plurality of clad layers (111,113,115,117) sandwiching said active layers.

2. A multi-active-layer semiconductor laser device according to Claim 1, wherein said clad layers (111,113,115,117) sandwiching said active layers include p-type and n-type clad layers.

3. A multi-active-layer semiconductor laser device according to Claim 1, wherein each of said clad layers sandwiching said active layers is a p-type or an n-type clad layer or an undoped layer.

# FIG. 1

# FIG. 2